# FASCICULE DE BREVET EUROPEEN

(11) **EP 0 776 075 B1**
(45) Date de publication et mention de la délivrance du brevet: **12.02.2003**
(21) Numéro de dépôt: 96402465.7
(22) Date de dépôt: 18.11.1996
(51) Int. Cl.: H01S 5/16, H01S 3/0941

(54) **Dispositif laser, notamment pour pompage optique**
Laservorrichtung, insbesondere zum optischen Pumpen
Laser device, in particular for optical pumping

(30) Priorité: 21.11.1995 FR 9513814
(43) Date de publication de la demande: 28.05.1997
(73) Titulaire: ALCATEL, 75382 Paris Cédex 08 (FR)
(72) Inventeur: Doussiere, Pierre, 91180 Saint Germain les Arpajons (FR); Riant, Isabelle, 91120 Palaiseau (FR)
(74) Mandataire: Fournier, Michel Robert Marie

(56) Documents cités:
- EP-A- 0 332 723
- EP-A- 0 553 994
- APPLIED PHYSICS LETTERS, vol. 54, no. 17, 24 Avril 1989, pages 1634-1636, XP000140141 BRYAN R P ET AL: "Nonplanar quantum well heterostructure window laser"
- ELECTRONICS LETTERS, vol. 30, no. 17, 18 Août 1994, page 1410/1411 XP000476032 SAGAWA M ET AL: "High power COD-free operation of 0.98um InGaAs/GaAs/InGaP lasers with non-injection regions near the facets"
- IEEE PHOTONICS TECHNOLOGY LETTERS, vol. 7, no. 1, 1 Janvier 1995, pages 111-113, XP000488134 MORTON P A ET AL: "Packaged hybrid soliton pulse source results and 270Terabit.km/sec soliton transmission"
- IEEE PHOTONICS TECHNOLOGY LETTERS, vol. 6, no. 8, Août 1994, pages 907-909, XP000465479 C.R.GILES ET AL.: "Simultaneous wavelength-stabilization of 980-nm pump lasers"
- PATENT ABSTRACTS OF JAPAN vol. 015, no. 454 (E-1135), 19 Novembre 1991 & JP 03 195076 A (ANRITSU CORP), 26 Août 1991,

## Description

L'invention se situe dans le domaine des dispositifs lasers où l'amplification optique est réalisée par une plaquette semiconductrice. Elle concerne plus particulièrement les lasers à semiconducteurs destinés à émettre une forte puissance optique. C'est le cas en particulier des lasers utilisés pour effectuer le pompage optique des amplificateurs à fibre dopée à l'erbium.

Dans cette application, on a besoin de lasers fournissant une puissance optique importante avec une longueur d'onde de 0,98 µm. On utilise habituellement des lasers semiconducteurs fabriqués sur des substrats d'arséniure de gallium qui permettent d'obtenir cette longueur d'onde. Ces lasers sont essentiellement constitués d'un amplificateur optique formé sur le substrat dont deux extrémités opposées sont clivées de façon à former une cavité résonnante. L'onde laser est produite dans une couche active de la partie amplificatrice. Cette couche a une section généralement rectangulaire, avec une largeur de 2 à 4 µm et une épaisseur de 0,1 µm à 0,2 µm. Il en résulte que l'onde lumineuse traversant la face de sortie du laser présente une densité d'énergie importante. Aussi, à partir d'un certain niveau de puissance, on constate une dégradation, voir une destruction de cette face.

Une solution connue à ce problème consiste à réaliser le clivage des faces sous ultravide et à traiter la face de sortie par un dépôt d'oxyde également sous ultravide. La couche d'oxyde réalise une passivation de la face qui la rend plus résistante aux fortes densités d'énergie. Cette technique est toutefois complexe car elle nécessite un équipement lourd (bâti d'ultravide) et n'est pas adaptée à une production de masse.

L'invention propose une autre approche qui vise à diminuer la densité d'énergie traversant la face plutôt qu'à chercher à la rendre plus résistante.

On pourrait penser à modifier la structure classique d'un laser semiconducteur en prévoyant à une extrémité un segment d'expansion permettant à la lumière issue de la couche active de se diffracter avant de rencontrer la face de sortie, comme cela est décrit dans l'article de R.P. Bryan et al., Appl. Phys. Lett. 54 (17), 24.04.1989, pp. 1634-1636, présentant un laser semiconducteur avec un segment d'expansion entre la couche active et la face de sortie. Cette solution n'est cependant pas satisfaisante car elle introduit des pertes intracavité qui réduisent le coefficient de réflexion effectif de la face de sortie et diminuent le rendement du laser. Aussi, pour préserver le fonctionnement du laser, la longueur du segment d'expansion doit être limitée, ce qui ne permet pas de réduire sensiblement la densité d'énergie.

Dans le but de résoudre ce problème, l'invention a pour objet un dispositif laser :
- un segment amplificateur comprenant une couche active formée dans une plaquette semiconductrice, ladite plaquette étant délimitée par une première et une seconde face,
- un premier et un second réflecteurs disposés de façon à former une cavité résonnante, ledit premier réflecteur étant extérieur à ladite plaquette,
caractérisé en ce qu'une fibre de couplage a une extrémité située à proximité de la première face, en ce que ledit premier réflecteur est formé dans ladite fibre de couplage et en ce que ladite plaquette contient un segment d'expansion adjacent à ladite première face pour permettre une expansion transversale de la lumière émise par la couche active avant qu'elle ne traverse ladite première face.

Le fait que le premier réflecteur soit formé dans la fibre de couplage permet un traitement antireflet de la face de sortie, ce qui supprime les réflexions intracavité et les sauts de mode qui peuvent en résulter.

Cette structure peut être utilisée pour tout type de substrat mais elle trouve un intérêt particulier dans le cas de l'arséniure de gallium qui présente une sensibilité particulière aux densités d'énergie importante. Dans ce cas, la longueur du segment d'expansion sera avantageusement comprise entre 10 et 50 µm de façon à permettre une expansion significative de l'onde lumineuse.

Le rendement du dispositif laser selon l'invention pourra être considérablement amélioré en apportant un soin particulier au couplage entre la fibre et la face de sortie. Pour cela, selon un aspect particulier de l'invention, l'extrémité de la fibre se termine en forme de dioptre dimensionné pour réaliser un couplage optique maximum avec la face.

Selon un autre aspect de réalisation, la fibre est une fibre photosensible et le réflecteur est un réseau de Bragg photo-inscrit dans la fibre. Cette solution présente l'avantage qu'elle permet dans tous les cas de réaliser un réseau du premier ordre. En effet, un tel réseau ne pourrait pas toujours être réalisé de façon intégrée, en particulier dans le cas de l'arséniure de gallium.

Avantageusement, la longueur du réseau photo-inscrit est comprise entre 1 et 5 mm. Selon un mode de réalisation préféré, la plaquette semiconductrice et l'extrémité de la fibre sont contenues dans un boîtier dont une paroi est traversée par la fibre et assure son maintien. Cette réalisation dite "packagée" permettra de protéger la partie de fibre contenant le réseau de contraintes mécaniques externes éventuelles qui modifieraient les caractéristiques du réseau.

Concernant la fabrication du dispositif et notamment du segment d'expansion, une solution pourrait consister à graver une extrémité de la plaquette après la formation de ces couches constitutives, puis de procéder sur cette zone à une croissance de substrat. Cette solution qui nécessite une reprise d'épitaxie peut cependant poser un problème car l'état de surface des plans gravés peut nuire aux propriétés optiques du dispositif. Ce problème est particulièrement difficile à surmonter dans le cas d'un substrat en arséniure de gallium.

Pour remédier à cette difficulté, on propose aussi un procédé de fabrication de la plaquette semiconductrice pour réaliser le segment d'expansion. Aussi, l'invention a également pour objet un procédé de fabrication comportant notamment :
- une première étape de croissance sur un substrat semiconducteur d'une couche d'alliage dopée,
- une seconde étape de croissance sur ladite couche dopée d'une couche active,
- une troisième étape de croissance sur ladite couche active d'une couche d'alliage dopée p, et
- des opérations de clivage pour former une première et une seconde face délimitant ladite plaquette,
caractérisé en ce que ladite première étape de croissance est précédée d'une étape de gravure du substrat sur toute la surface du substrat à l'exception d'une zone voisine d'une desdites faces de façon à former dans la plaquette un segment d'expansion permettant une expansion transversale de la lumière émise par la couche active.

La mise en oeuvre de procédé aura pour conséquence que la couche active s'étend sur toute la longueur de la plaquette et se situe dans un même plan à l'exception de sa partie qui se trouve dans le segment d'expansion.

D'autres aspects et avantages de l'invention apparaîtront dans la suite de la description en référence aux figures.
- la figure 1 est une représentation schématique du dispositif laser selon l'invention.
- la figure 2 montre un détail de la plaquette semiconductrice obtenu grâce au procédé selon l'invention.
- la figure 3 montre schématiquement un mode de réalisation "packagée" du dispositif laser selon l'invention.

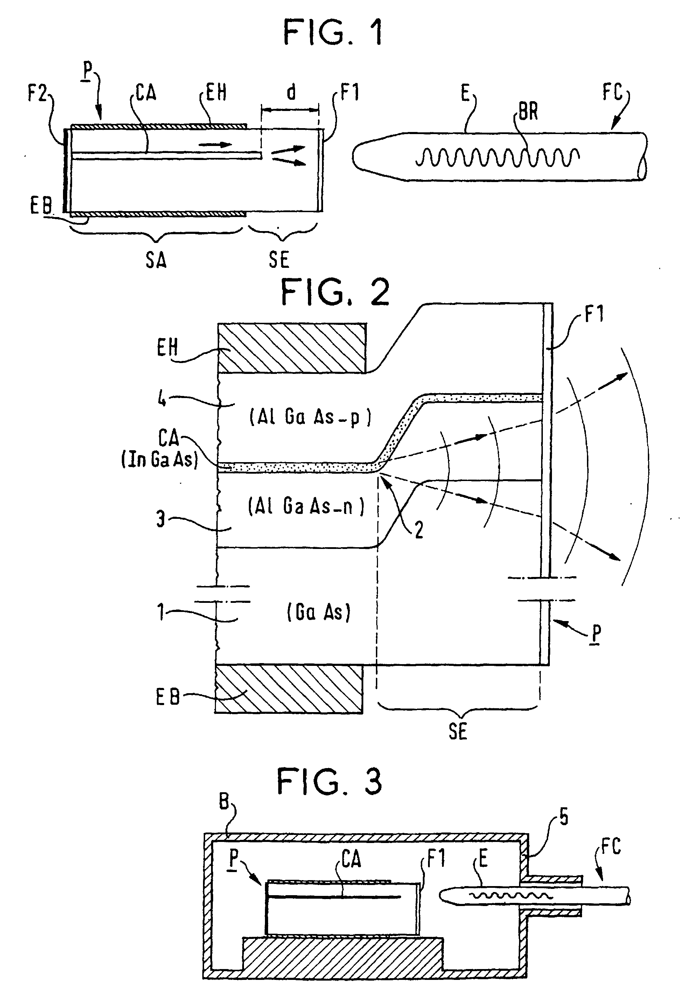

Le dispositif laser apparaît schématiquement à la figure 1. Il est constitué d'une plaquette semiconductrice P et d'une fibre de couplage FC dont seule l'extrémité E est représentée. La plaquette P comporte un segment d'amplication SA contenant une couche active CA à travers laquelle peut être injectée un courant électrique par l'intermédiaire d'électrodes supérieur EH et inférieur EB. La plaquette est délimitée longitudinalement par deux faces clivées F1, F2. La face F2 est réfléchissante et comporte éventuellement un traitement diélectrique pour augmenter sa réflectivité et forcer l'émission laser par la face avant. La face F1 est par contre munie d'un revêtement antiréfléchissant. Une des extrémités guidantes de la couche active CA est séparée de la face transparente F1 par un segment d'expansion SE formé dans une extrémité de la plaquette P. L'extrémité E de la fibre FC est plaçée à proximité de la face F1 à une distance permettant un couplage optique optimal avec la plaquette. L'extrémité E contient un réseau de Bragg BR. Dans le cas où la fibre est photosensible, le réseau BR pourra être photo-inscrit par un procédé connu. Le pas du réseau BR sera choisi pour s'accorder au premier ordre avec la longueur d'onde choisie pour le dispositif. Ainsi, dans le cas d'un substrat en arséniure de gallium, la longueur d'onde sera de 0,98 µm, ce qui impose pour une fibre d'indice effectif voisin de 1,5 un pas de 0,35 µm.

Avantageusement, l'extrémité E de la fibre se termine en dioptre dont la forme est choisie pour optimiser le couplage. On pourra ainsi obtenir un coefficient de couplage de l'ordre de 0,5. Le coefficient de réflexion du réseau de Bragg BR pourra alors être de l'ordre de 0,10, le coefficient de réflexion de la face F1 étant négligeable.

La figure 2 montre plus en détails la structure de la plaquette au voisinage du segment d'expansion SE, dans le cas où on utilise le procédé selon l'invention.

Selon cet exemple, la plaquette est fabriquée à partir du substrat 1 en arséniure de gallium auquel on fait subir une gravure sur presque toute sa surface à l'exception de la zone destinée à devenir le segment d'expansion SE. On effectue ensuite une croissance sur le substrat de l'alliage ternaire AlGaAs dopé n. On forme ensuite la couche active CA composée de l'alliage InGaAs ou InGaAsP. On forme enfin la couche 4 composée de l'alliage AlGaAs dopé p.

Ainsi, la gravure localisée du substrat 1 a pour conséquence que la couche active CA présente une courbure 2 importante dans le plan vertical, ce qui supprime sa propriété de guidage optique à partir de cette courbure.

Le segment d'expansion SE est alors équivalent à une zône de diffraction permettant un étalement de l'onde issue de la couche active. cette solution présente l'avantage d'éviter tout problème d'état de surface occasionné par une gravure des couches AlGaAs.

La figure 3 représente une réalisation packagée du dispositif selon l'invention. La plaquette P est fixée à l'intérieur d'un boîtier B. La fibre FC traverse la paroi 5 du boîtier de sorte que l'extrémité E se trouve à l'intérieur du boîtier et soit positionnée devant la face F1 à la hauteur de la couche active CA. Comme représenté schématiquement, la paroi 5 est aménagée pour assurer un bon maintien de l'extrémité de la fibre par rapport au boîtier.

Bien entendu, les figures qui viennent d'être décrites ne sont que des représentations schématiques qui pour des raisons de clarté, ne respectent pas les proportions d'un dispositif réel. Ainsi, pour un dispositif laser GaAs accordé à une longueur d'onde de 0,98 µm, les ordres de grandeurs de dimensionnement pourront être les suivantes :
- Longueur de la couche active : 600 µm à 1 mm
- Largeur de la couche active : 2 à 4 µm
- Epaisseur de la couche active : 0,1 à 0,2 µm
- Longueur d du segment d'expansion : 10 à 50 µm
- Distance entre la face F1 et l'extrémité de la fibre : 5 à 30 µm
- Longueur du réseau de Bragg BR : 1 à 5 mm
- Indice effectif de la fibre : environ 1,5
- Pas du réseau de Bragg : environ 0,35 µm

## Revendications

1. Dispositif laser pour pompage optique comportant un segment amplificateur (SA) comprenant une couche active (CA) formée dans une plaquette semiconductrice (P), ladite plaquette (P) étant délimitée par une première et une seconde faces (F1, F2) et contenant un segment d'expansion (SE) adjacent à ladite première face (F1) pour permettre une expansion transversale de la lumière émise par la couche active (CA) avant qu'elle ne traverse ladite première face (F1), ladite couche active (CA) étant disposée entre un premier et un second réflecteurs (BR, F2) formant une cavité résonnante, **caractérisé en ce que** ledit premier réflecteur (BR) est formé dans une fibre de couplage (FC) dont une extrémité (E) est située à proximité de ladite première face (F1), ladite première face (F1) étant munie d'un revêtement antiréfléchissant.

2. Dispositif laser selon la revendication 1, **caractérisé en ce que** ladite couche active (CA) s'étend sur toute la longueur de la plaquette (P) et se situe dans un même plan à l'exception de sa partie qui se trouve dans ledit segment d'expansion (SE).

3. Dispositif laser selon l'une des revendications 1 ou 2, **caractérisé en ce que** ladite plaquette (P) est formée à partir d'un substrat (1) composé d'arséniure de gallium.

4. Dispositif laser selon la revendication 3, **caractérisé en ce que** ledit segment d'expansion (SE) a une longueur (d) comprise entre 10 et 50 µm.

5. Dispositif laser selon l'une des revendications 1 à 4, **caractérisé en ce que** ladite extrémité (E) de la fibre de couplage (FC) se termine en forme de dioptre dimensionné pour réaliser un couplage optique maximum avec ladite plaquette (P).

6. Dispositif laser selon l'une des revendications 1 à 5, **caractérisé en ce que** ladite fibre (FC) est une fibre photosensible et **en ce que** ledit premier réflecteur (BR) est un réseau de Bragg photo-inscrit dans l'extrémité (E) de la fibre de couplage (FC).

7. Dispositif laser selon la revendication 6, **caractérisé en ce que** ledit réseau de Bragg (BR) a une longueur comprise entre 1 et 5 mm.

8. Dispositif laser selon l'une des revendications 1 à 7, **caractérisé en ce que** ladite plaquette (P) et ladite extrémité de fibre (E) sont contenues dans un boîtier (B) dont une paroi (5) est traversée par la fibre de couplage (FC) et assure son maintien.

9. Utilisation du dispositif laser selon l'une des revendications 1 à 8, pour effectuer le pompage optique de fibres dopées à l'erbium.

## Patentansprüche

1. Laservorrichtung zum optischen Pumpen, welche ein Verstärkersegment (SA) aufweist, das eine aktive Schicht (CA) aufweist, die in einem Halbleiterplättchen (P) ausgebildet ist, wobei das Plättchen (P) von einer ersten und einer zweiten Fläche (F1, F2) begrenzt wird und benachbart zur ersten Fläche (F1) ein Expansionssegment (SE) beinhaltet, um eine Expansion in Transversalrichtung des von der aktiven Schicht (CA) emittierten Lichtes zu ermöglichen, bevor dieses durch die erste Fläche (F1) hindurchgeht, und die aktive Schicht (CA) zwischen einem ersten und einem zweiten Reflektor (BR, F2) angeordnet ist, die einen Resonanzraum bilden, **dadurch gekennzeichnet, dass** der erste Reflektor (BR) in einer Kopplungsfaser (FC) ausgebildet ist, deren eines Ende (E) sich in der Nähe der ersten Fläche (F1) befindet, wobei die erste Fläche (F1) mit einer Anti-Reflexbeschichtung versehen ist.

2. Laservorrichtung nach Anspruch 1, **dadurch gekennzeichnet, dass** die aktive Schicht (CA) sich über die gesamte Länge des Plättchens (P) erstreckt und sich in derselben Ebene befindet, mit Ausnahme ihres im Expansionssegment (SE) befindlichen Teils.

3. Laservorrichtung nach einem der Ansprüche 1 oder 2, **dadurch gekennzeichnet, dass** das Plättchen (P) aus einem aus Galliumarsenid bestehenden Substrat (1) aufgebaut ist.

4. Laservorrichtung nach Anspruch 3, **dadurch gekennzeichnet, dass** das Expansionssegment (SE) eine Länge (d) zwischen 10 und 50 µm hat.

5. Laservorrichtung nach einem der Ansprüche 1 bis 4, **dadurch gekennzeichnet, dass** das Ende (E) der Kopplungsfaser (FC) in Form eines Diopters endet, dessen Abmessungen derart sind, dass eine maximale optische Kopplung mit dem Plättchen (P) realisiert wird.

6. Laservorrichtung nach einem der Ansprüche 1 bis 5, **dadurch gekennzeichnet, dass** es sich bei der Faser (FC) um eine photosensible Faser handelt und dass der erste Reflektor (BR) ein Bragg-Gitter ist, das am Ende (E) der Kopplungsfaser (FC) durch Photo-Einschreiben erzeugt ist.

7. Laservorrichtung nach Anspruch 6, **dadurch gekennzeichnet, dass** das Bragg-Gitter (BR) eine Länge zwischen 1 und 5 mm hat.

8. Laservorrichtung nach einem der Ansprüche 1 bis 7, **dadurch gekennzeichnet, dass** das Plänchen (P) und das Faserende (E) sich in einem Gehäuse (B) befinden, dessen eine Wand (5) von der Kopplungsfäser (FC) durchstoßen wird und diese in ihrer Position hält.

9. Anwendung der Laservorrichtung nach einem der Ansprüche 1 bis 8 zur Durchführung des optischen Pumpens von Erbium-dotierten Fasern.

## Claims

1. A laser device for optical pumping comprising an amplifier segment (SA) comprising an active layer (CA) formed in a semiconductor wafer (P) delimited by first and second facets (F1, F2), and including an expansion segment (SE) adjacent said first facet (F1) to enable transverse expansion of light emitted by the active layer (CA) before it passes through said first facet (F1), said active layer (CA) being disposed between first and second mirrors (BR, F2) forming a resonant cavity, **characterized in that** said first mirror (BR) is formed in a coupling fibre (FC) which has one end (E) disposed near said first facet (F1), said first facet (F1) having an anti-reflection coating.

2. A laser device according to claim 1 **characterized in that** said active layer (CA) extends the whole length of the wafer (P) and lies in one plane except for its part that is in said expansion segment (SE).

3. A laser device according to either claim 1 or claim 2 **characterized in that** said wafer (P) is formed from a gallium arsenide substrate (1).

4. A laser device according to claim 3 **characterized in that** said expansion segment (SE) has a length (d) between 10µm and 50 µm.

5. A laser device according to any of claims 1 to 4 **characterized in that** said end portion (E) of the coupling fibre (FC) terminates in the form of a diopter dimensioned for maximum optical coupling with said wafer (P).

6. A laser device according to any of claims 1 to 5 **characterized in that** said fibre (FC) is a photosensitive fibre and **in that** said first mirror (BR) is a Bragg grating written by optical means in the end portion (E) of the coupling fibre (FC).

7. A laser device according to claim 6 **characterized in that** said Bragg grating (BR) is between 1 mm and 5 mm long.

8. A laser device according to any of claims 1 to 7 **characterized in that** said wafer (P) and said end portion (E) of said fibre are contained in a casing (B) through a wall (5) of which the coupling fibre (FC) passes and by which wall said fibre is held.

9. Use of the laser device according to any of claims 1 to 8 for optical pumping of erbium-doped fibres.
